(19) **Europäisches Patentamt**
**European Patent Office**
**Office européen des brevets**

(11) **EP 0 983 614 B1**

(12) **EUROPÄISCHE PATENTSCHRIFT**

(45) Veröffentlichungstag und Bekanntmachung des Hinweises auf die Patenterteilung:
**09.06.2010 Patentblatt 2010/23**

(21) Anmeldenummer: **99906038.7**

(22) Anmeldetag: **12.01.1999**

(51) Int Cl.:
**H01L 41/04** (2006.01)

(86) Internationale Anmeldenummer:
**PCT/DE1999/000033**

(87) Internationale Veröffentlichungsnummer:
**WO 1999/041790 (19.08.1999 Gazette 1999/33)**

(54) **VERFAHREN UND VORRICHTUNG ZUM ERMITTELN DER TEMPERATUR EINES PIEZOELEKTRISCHEN ELEMENTS**

METHOD AND DEVICE FOR DETERMINING THE TEMPERATURE OF A PIEZO-ELECTRIC ELEMENT

PROCEDE ET DISPOSITIF POUR DETERMINER LA TEMPERATURE D'UN ELEMENT PIEZO-ELECTRIQUE

(84) Benannte Vertragsstaaten:
**DE FR GB IT**

(30) Priorität: **10.02.1998 DE 19805184**

(43) Veröffentlichungstag der Anmeldung:
**08.03.2000 Patentblatt 2000/10**

(73) Patentinhaber: **ROBERT BOSCH GMBH**
**70442 Stuttgart (DE)**

(72) Erfinder:
• **REINEKE, Jörg**
**D-70469 Stuttgart (DE)**
• **HOCK, Alexander**
**D-70435 Stuttgart (DE)**

(56) Entgegenhaltungen:
**WO-A-98/27600     US-A- 5 543 679**

• **PATENT ABSTRACTS OF JAPAN vol. 018, no. 447 (E-1594), 19. August 1994 & JP 06 140682 A (TOYOTA MOTOR CORP), 20. Mai 1994**

**Beschreibung**

Die vorliegende Erfindung betrifft ein Verfahren gemäß dem Oberbegriff des Patentanspruchs 1 und eine Vorrichtung gemäß dem Oberbegriff des Patentanspruchs 2, d. h. ein Verfahren und eine Vorrichtung zum Ermitteln der Temperatur eines piezoelektrischen Elements.

Bei den vorliegend näher betrachteten piezoelektrischen Elementen handelt es sich insbesondere, aber nicht ausschließlich um als Aktoren bzw. Stellglieder verwendete piezoelektrische Elemente. Piezoelektrische Elemente lassen sich für derartige Zwecke einsetzen, weil sie bekanntermaßen die Eigenschaft aufweisen, sich in Abhängigkeit von einer daran angelegten Spannung zusammenzuziehen oder auszudehnen.

Die praktische Realisierung von Stellgliedern durch piezoelektrische Elemente erweist sich insbesondere dann von Vorteil, wenn das betreffende Stellglied schnelle und/oder häufige Bewegungen auszuführen hat.

Der Einsatz von piezoelektrischen Elementen als Stellglied erweist sich unter anderem bei Kraftstoff-Einspritzdüsen für Brennkraftmaschinen als vorteilhaft. Zur Einsetzbarkeit von piezoelektrischen Elementen in Kraftstoff-Einspritzdüsen wird beispielsweise auf die EP 0 371 469 B1 und die EP 0 379 182 B1 verwiesen.

Piezoelektrische Elemente sind kapazitive Verbraucher, welche sich, wie vorstehend bereits angedeutet wurde, entsprechend dem jeweiligen Ladungszustand bzw. der sich daran einstellenden oder angelegten Spannung zusammenziehen und ausdehnen.

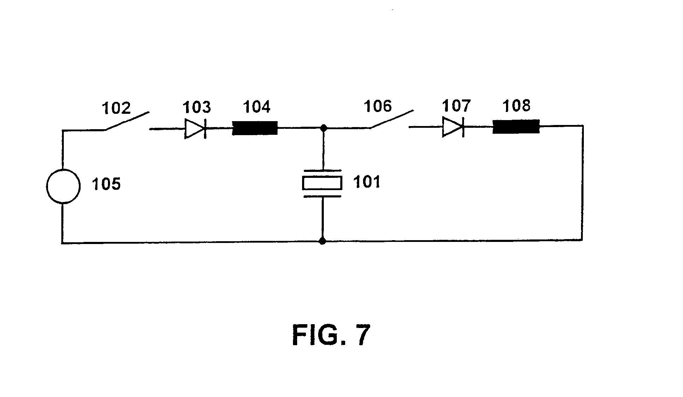

Das Laden und Entladen eines piezoelektrischen Elements kann unter anderem über ein induktive Eigenschaften aufweisendes Bauelement wie beispielsweise eine Spule erfolgen, wobei diese Spule in erster Linie dazu dient, den beim Laden auftretenden Ladestrom und den beim Entladen auftretenden Entladestrom zu begrenzen. Eine solche Anordnung ist in Fig. 7 veranschaulicht.

Das zu ladende bzw. zu entladende piezoelektrische Element ist in der Fig. 7 mit dem Bezugszeichen 101 bezeichnet. Es ist Bestandteil eines über einen Ladeschalter 102 schließbaren Ladestromkreises und eines über einen Entladeschalter 106 schließbaren Entladestromkreises, wobei der Ladestromkreis aus einer Serienschaltung des Ladeschalters 102, einer Diode 103, einer Ladespule 104, des piezoelektrischen Elements 101, und einer Spannungsquelle 105 besteht, und wobei der Entladestromkreis aus einer Serienschaltung des Entladeschalters 106, einer Diode 107, einer Entladespule 108 und des piezoelektrischen Elements 101 besteht.

Die Diode 103 des Ladestromkreises verhindert, dass im Ladestromkreis ein das piezoelektrische Element entladender Strom fließen kann. Die Diode 103 und der Ladeschalter 102 sind gemeinsam als ein Halbleiterschalter realisierbar.

Die Diode 107 des Entladestromkreises verhindert, dass im Entladestromkreis ein das piezoelektrische Element ladender Strom fließen kann. Die Diode 107 und der Ladeschalter 106 sind wie die Diode 103 und der Ladeschalter 102 gemeinsam als ein Halbleiterschalter realisierbar.

Wird der normalerweise geöffnete Ladeschalter 102 geschlossen, so fließt im Ladestromkreis ein Ladestrom, durch welchen das piezoelektrische Element 101 geladen wird; die im piezoelektrischen Element 101 gespeicherte Ladung bzw. die sich an diesem dadurch einstellende Spannung und damit auch die aktuellen äußeren Abmessungen des piezoelektrischen Elements 101 werden nach dem Laden desselben im wesentlichen unverändert beibehalten.

Wird der normalerweise ebenfalls geöffnete Entladeschalter 106 geschlossen, so fließt im Entladestromkreis ein Entladestrom, durch welchen das piezoelektrische Element 101 entladen wird; der Ladezustand des piezoelektrischen Elements 101 bzw. die sich an diesem dadurch einstellende Spannung und damit auch die aktuellen äußeren Abmessungen des piezoelektrischen Elements 101 werden nach dem Entladen desselben im wesentlichen unverändert beibehalten.

Durch die in der Fig. 7 gezeigte Anordnung lässt sich das piezoelektrische Element 101 mit relativ geringem Aufwand laden und entladen.

Das Verhalten des piezoelektrischen Elements, insbesondere die durch das Laden und Entladen bewirkte Längenänderung (der Hub) desselben ist allerdings stark temperaturabhängig. Damit piezoelektrische Elemente als Stellglieder bzw. Aktoren in Kraftstoff-Einspritzdüsen eingesetzt werden können, müssen sie abhängig von deren Temperatur geladen und entladen werden. Zur Erfassung der Temperatur des piezoelektrischen Elements kann beispielsweise ein Temperatursensor verwendet werden, der auf das piezoelektrische Element aufgeklebt wird. Dies ist jedoch relativ aufwendig und kann das betreffende piezoelektrische Element auch in seiner Funktion beeinflussen.

Aus dem Patent Abstracts of Japan, Vol.018,Nr.447 (E-1594), 19. August 1994, &JP 06 140682 A ist eine Einrichtung bekannt, bei der die Temperatur eines Piezoaktors ausgehend von der Ladung und der Spannung eines zweiten Kondensators bestimmt wird. Hierzu wird mittels einer Spannungserfassungsschaltung die Spannung vor und nach dem Ladevorgang an einem zusätzlichen Kondensator erfasst. Eine Schaltung berechnet ausgehend von dieser Spannung die Ladung Q, welche vom Kondensator auf das piezoelektrische Element übertragen wurde. Eine Temperaturberechnung 18 berechnet die Temperatur des Piezoaktors ausgehend von der Spannung vor und der Spannung nach dem Ladevorgang. Eine Berücksichtigung der Kapazität des Piezoaktors ist nicht vorgesehen.

Der vorliegenden Erfindung liegt daher die Aufgabe zugrunde, das Verfahren gemäß dem Oberbegriff des Patentanspruchs 1 bzw. die Vorrichtung gemäß dem Oberbegriff des Patentanspruchs 2 derart weiterzubilden, dass sich die Temperatur von piezoelektrischen Elementen möglichst einfach und ohne Beeinflussung deren Funktion ermitteln lässt.

Diese Aufgabe wird erfindungsgemäß durch die im kennzeichnenden Teil des Patentanspruchs 1 (Verfahren) und durch die im kennzeichnenden Teil des Patentanspruchs 2 (Vorrichtung) beanspruchten Merkmale gelöst.

Demnach ist vorgesehen, die Kapazität des piezoelektrischen Elements bei der gesuchten Temperatur zu ermitteln, und die gesuchte Temperatur des piezoelektrischen Elements basierend auf der ermittelten Kapazität und der Temperaturabhängigkeit der Kapazität zu bestimmen und die Kapazität des piezoelektrischen Elements (1) basierend auf den während eines Ladevorganges oder Entladevorganges ermittelten oder verwendeten Werten des Lade- oder Entladestromes, der Lade- oder Entladezeit und der sich dadurch am piezoelektrischen Element einstellenden Spannung zu berechnen.

Die Ermittlung der Temperatur des piezoelektrischen Elements auf dem Umweg über dessen Kapazität und deren Temperaturabhängigkeit erweist sich als relativ einfach, da die Abhängigkeit der Kapazität des piezoelektrischen Elements von dessen Temperatur nahezu linear ist, und die Ermittlung der Kapazität des piezoelektrischen Elements mit relativ geringem Aufwand durchführbar ist. So läst sich die Kapazität aus bei einem Lade-oder Entladevorgang ermittelten oder verwendeten Werten des Entladestroms oder Ladestroms, der Entladezeit oder Ladezeit und der sich dabei am piezoelektrischen Element einstellenden Spannung berechnen.

Auf das Vorsehen eines Temperatursensors kann verzichtet werden; die Temperatur kann auch ohne einen solchen Sensor, also einfach und gänzlich ohne Beeinflussung der Funktion des piezoelektrischen Elements ermittelt werden.

Vorteilhafte Weiterbildungen der Erfindung sind den Unteransprüchen, der folgenden Beschreibung und den Figuren entnehmbar.

Die Erfindung wird nachfolgend anhand von Ausführungsbeispielen unter Bezugnahme auf die Zeichnung näher erläutert. Es zeigen

Figur 1     eine Anordnung zum Laden und Entladen eines piezo- elektrischen Elements mit einstellbarem Lade- bzw. Entladestrom,

Figur 2     eine Darstellung zur Erläuterung der sich während einer ersten Ladephase (Ladeschalter 3 geschlossen) in der Anordnung nach Figur 1 einstellenden Verhält- nisse,

Figur 3     eine Darstellung zur Erläuterung der sich während einer zweiten Ladephase (Ladeschalter 3 wieder ge- öffnet) in der Anordnung nach Figur 1 einstellenden Verhältnisse,

Figur 4     eine Darstellung zur Erläuterung der sich während einer ersten Entladephase (Entladeschalter 5 ge- schlossen) in der Anordnung nach Figur 1 einstellen- den Verhältnisse,

Figur 5     eine Darstellung zur Erläuterung der sich während einer zweiten Entladephase (Entladeschalter 5 wieder geöffnet) in der Anordnung nach Figur 1 einstellenden Verhältnisse,

Figur 6     den zeitlichen Verlauf von sich beim Betrieb der An- ordnung gemäß Figur 1 einstellenden Spannungs- und Stromverläufen, und

Figur 7     eine herkömmliche Anordnung zum Laden und Entladen eines piezoelektrischen Elements.

Die piezoelektrischen Elemente, deren Laden und Entladen im folgenden näher beschrieben wird, sind beispielsweise als Stellglieder in Kraftstoff-Einspritzdüsen (insbesondere in sogenannten Common Rail Injektoren) von Brennkraftmaschinen einsetzbar. Auf einen derartigen Einsatz der piezoelektrischen Elemente besteht jedoch keinerlei Einschränkung; die piezoelektrischen Elemente können grundsätzlich in beliebigen Vorrichtungen für beliebige Zwecke eingesetzt werden.

Es wird davon ausgegangen, daß sich die piezoelektrischen Elemente im Ansprechen auf das Laden ausdehnen und im Ansprechen auf das Entladen zusammenziehen. Die Erfindung ist selbstverständlich jedoch auch dann anwendbar, wenn dies gerade umgekehrt ist.

Das beschriebene Verfahren und die beschriebene Vorrichtung sind im betrachteten Beispiel insbesondere dazu ausgelegt, den das piezoelektrische Element ladenden Ladestrom und den das piezoelektrische Element entladenden Entladestrom unter Berücksichtigung der Temperatur des piezoelektrischen Elements einzustellen, wobei die Ermittlung der Temperatur des piezoelektrischen Elements durch Ermitteln der Kapazität des piezoelektrischen Elements bei der gesuchten Temperatur, und Bestimmen der gesuchten Temperatur des piezoelektrischen Elements basierend auf der ermittelten Kapazität und der Temperaturabhängikeit der Kapazität erfolgt.

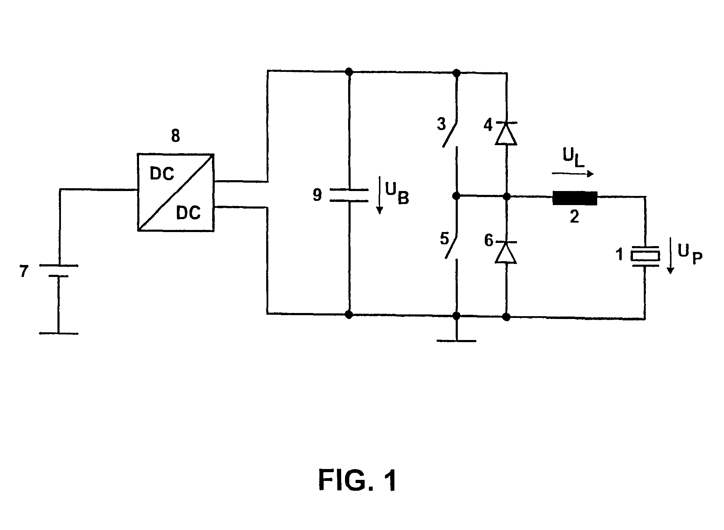

Eine Anordnung zum Laden und Entladen eines piezoelektrischen Elements mit einstellbarem Lade- und Entladestrom ist in Figur 1 gezeigt und wird nachfolgend unter Bezugnahme darauf beschrieben.

Das piezoelektrische Element, das es im betrachteten Beispiel zu laden gilt, ist in der Figur 1 mit dem Bezugszeichen 1 bezeichnet.

Wie aus der Figur 1 ersichtlich ist, liegt der eine der Anschlüsse des piezoelektrischen Elements 1 dauerhaft auf Masse (ist mit einem ersten Pol einer Spannungsquelle verbunden), wohingegen der andere der Anschlüsse des piezoelektrischen Elements über eine (zugleich als Ladespule und Entladespule wirkende) Spule 2 und eine Parallelschaltung aus einem Ladeschalter 3 und einer Diode 4 mit dem zweiten Pol der Spannungsquelle und über die Spule 2 und eine Parallelschaltung aus einem Entladeschalter 5 und einer Diode 6 mit dem ersten Pol der Spannungsquelle verbunden ist.

Die Spannungsquelle besteht aus einer Batterie 7 (beispielsweise einer KFZ-Batterie), einem dieser nachgeschalteten Gleichspannungswandler 8, und einem diesem nachgeschalteten, als Pufferkondensator dienenden Kondensator 9. Durch diese Anordnung wird die Batteriespannung (beispielsweise 12 V) in eine im wesentlichen beliebige andere Gleichspannung umgesetzt und als Versorgungsspannung bereitgestellt.

Das Laden und das Entladen des piezoelektrischen Elements 1 erfolgen im betrachteten Beispiel getaktet. D.h., der Ladeschalter 3 und der Entladeschalter 5 werden während des Lade- bzw. Entladevorganges wiederholt geschlossen und geöffnet.

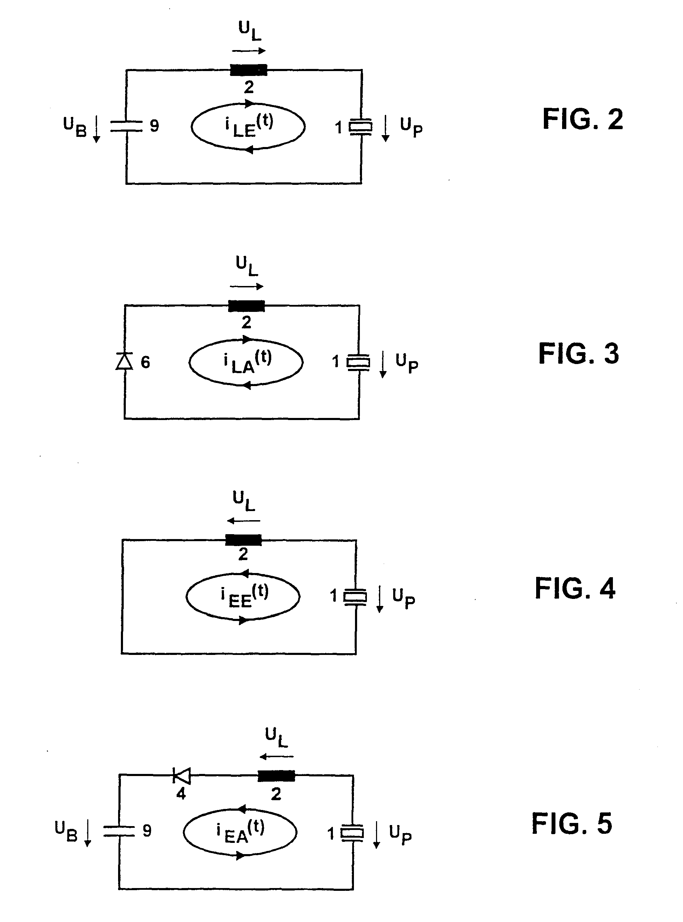

Die sich dabei einstellenden Verhältnisse werden nachfolgend unter Bezugnahme auf die Figuren 2 bis 5 erläutert, von denen die Figuren 2 und 3 das Laden des piezoelektrischen Elements 1, und die Figuren 4 und 5 das Entladen des piezoelektrischen Elements 1 veranschaulichen.

Der Ladeschalter 3 und der Entladeschalter 5 sind, wenn und solange kein Laden oder Entladen des piezoelektrischen Elements 1 erfolgt, geöffnet. In diesem Zustand befindet sich die in der Figur 1 gezeigte Schaltung im stationären Zustand. D.h., das piezoelektrische Element 1 behält seinen Ladungszustand im wesentlichen unverändert bei, und es fließen keine Ströme.

Mit dem Beginn des Ladens des piezoelektrischen Elements 1 wird der Ladeschalter 3 wiederholt geschlossen und geöffnet; der Entladeschalter 5 bleibt hierbei geöffnet.

Beim Schließen des Ladeschalters 3 stellen sich die in der Figur 2 gezeigten Verhältnisse ein. D.h., es wird ein aus einer Reihenschaltung aus dem piezoelektrischen Element 1, dem Kondensator 9 und der Spule 2 bestehender geschlossener Stromkreis gebildet, in welchem ein wie in der Figur 2 durch Pfeile angedeuteter Strom $i_{LE}(t)$ fließt. Dieser Stromfluß bewirkt, daß in der Spule 2 Energie gespeichert wird. Der Energiefluß in die Spule 2 wird dabei durch die positive Potentialdifferenz zwischen dem Kondensator 9 und dem piezoelektrischen Element 1 bewirkt.

Beim kurz (beispielsweise einige μs) nach dem Schließen des Ladeschalters 3 erfolgenden Öffnen desselben stellen sich die in der Figur 3 gezeigten Verhältnisse ein. D.h., es wird ein aus einer Reihenschaltung aus dem piezoelektrischen Element 1, der Diode 6 und der Spule 2 bestehender geschlossener Stromkreis gebildet, in welchem ein wie in der Figur 3 durch Pfeile angedeuteter Strom $i_{LA}(t)$ fließt. Dieser Stromfluß bewirkt, daß in der Spule 2 gespeicherte Energie vollständig in das piezoelektrische Element 1 fließt. Entsprechend der Energiezufuhr zum piezoelektrischen Element erhöhen sich die an diesem einstellende Spannung und dessen äußere Abmessungen. Nach erfolgtem Energietransport von der Spule 2 zum piezoelektrischen Element 1 ist wieder der vorstehend bereits erwähnte stationäre Zustand der Schaltung nach Figur 1 erreicht.

Dann oder auch schon vorher oder auch erst später (je nach dem gewünschten zeitlichen Verlauf des Ladevorgangs) wird der Ladeschalter 3 erneut geschlossen und wieder geöffnet, wobei sich die vorstehend beschriebenen Vorgänge wiederholen. Durch das erneute Schließen und Öffnen des Ladeschalters 3 nimmt die im piezoelektrischen Element 1 gespeicherte Energie zu (die im piezoelektrischen Element bereits gespeicherte Energie und die neu zugeführte Energie summieren sich), und dementsprechend nehmen die sich am piezoelektrischen Element einstellende Spannung und dessen äußere Abmessungen zu.

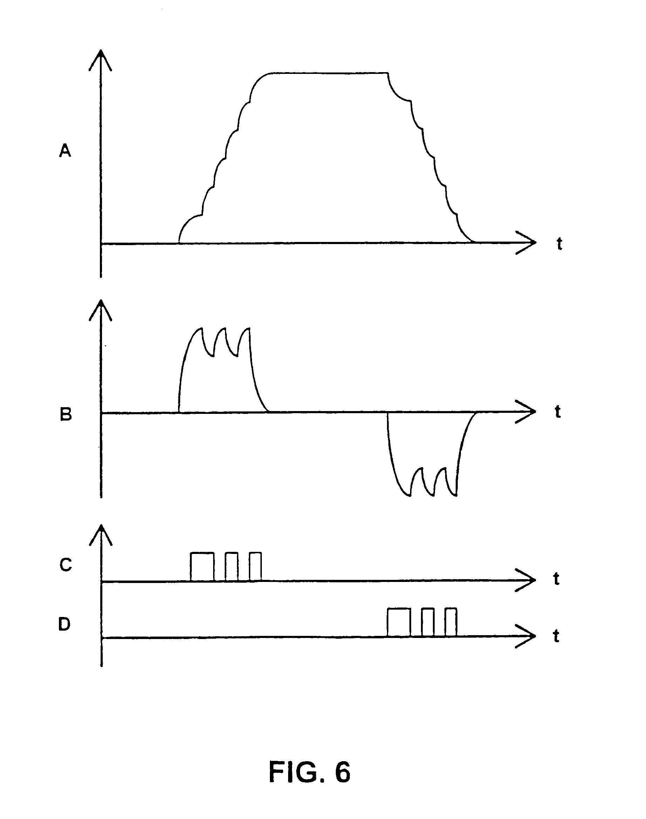

Wiederholt man das beschriebene Schließen und Öffnen des Ladeschalters 3 eine Vielzahl von Malen, so steigen die sich am piezoelektrischen Element einstellende Spannung und die Ausdehnung des piezoelektrischen Elements stufenweise an (siehe hierzu die Kurve A der später noch genauer erläuterten Figur 6).

Wurde der Ladeschalter 3 während einer vorbestimmten Zeit und/oder eine vorbestimmte Anzahl von Malen geschlossen und geöffnet und/oder hat das piezoelektrische Element 1 den gewünschten Ladezustand erreicht, so wird das Laden des piezoelektrischen Elements durch Offenlassen des Ladeschalters 3 beendet.

Soll das piezoelektrische Element 1 wieder entladen werden, so wird dies durch ein wiederholtes Schließen und Öffnen des Entladeschalters 5 bewerkstelligt; der Ladeschalter 3 bleibt hierbei geöffnet.

Beim Schließen des Entladeschalters 5 stellen sich die in der Figur 4 gezeigten Verhältnisse ein. D.h., es wird ein aus einer Reihenschaltung aus dem piezoelektrischen Element 1 und der Spule 2 bestehender geschlossener Stromkreis gebildet, in welchem ein wie in der Figur durch Pfeile angedeuteter Strom $i_{EE}(t)$ fließt. Dieser Stromfluß bewirkt, daß die im piezoelektrischen Element gespeicherte Energie (ein Teil derselben) in die Spule 2 transportiert wird. Entsprechend dem Energietransfer vom piezoelektrischen Element 1 zur Spule 2 nehmen die sich am piezoelektrischen Element einstellende Spannung und dessen äußere Abmessungen ab.

Beim kurz (beispielsweise einige μs) nach dem Schließen des Entladeschalters 5 erfolgenden Öffnen desselben stellen sich die in der Figur 5 gezeigten Verhältnisse ein. D.h., es wird ein aus einer Reihenschaltung aus dem piezoelektrischen Element 1, dem Kondensator 9, der Diode 4 und der Spule 2 bestehender geschlossener Stromkreis gebildet, in welchem ein wie in der Figur durch Pfeile angedeuteter Strom $i_{EA}$ (t) fließt. Dieser Stromfluß bewirkt, daß in der Spule 2 gespeicherte Energie vollständig in den Kondensator 9 zurückgespeist wird. Nach erfolgtem Energietransport von der Spule 2 zum Kondensator 9 ist wieder der vorstehend bereits erwähnte stationäre Zustand der Schaltung nach Figur 1 erreicht.

Dann oder auch schon vorher oder erst später (je nach dem gewünschten zeitlichen Verlauf des Entladevorgangs) wird der Entladeschalter 5 erneut geschlossen und wieder geöffnet, wobei sich die vorstehend beschriebenen Vorgänge wiederholen. Durch das erneute Schließen und Öffnen des Entladeschalters 5 nimmt die im piezoelektrischen Element 1 gespeicherte Energie weiter ab, und dementsprechend nehmen die sich am piezoelektrischen Element einstellende Spannung und dessen äußere Abmessungen ebenfalls ab.

Wiederholt man das beschriebene Schließen und Öffnen des Entladeschalters 5 eine Vielzahl von Malen, so nehmen die sich am piezoelektrischen Element einstellende Spannung und die Ausdehnung des piezoelektrischen Elements stufenweise ab (siehe hierzu die Kurve A in der Figur 6).

Wurde der Entladeschalter 5 während einer vorbestimmten Zeit und/oder eine vorbestimmte Anzahl von Malen geschlossen und geöffnet und/oder hat das piezoelektrische Element den gewünschten Entladezustand erreicht, so wird das Entladen des piezoelektrischen Elements durch Offenlassen des Entladeschalters 5 beendet.

Das Ausmaß und der Verlauf des Ladens und des Entladens sind durch die Häufigkeit und die Dauer des Öffnens und Schließens des Ladeschalters 3 und des Entladeschalters 5 bestimmbar. Dies gilt nicht nur für die in der Figur 1 gezeigte Anordnung, sondern für alle Anordnungen, durch welche ein vergleichbares Laden und/oder Entladen von piezoelektrischen Elementen durchführbar ist; die besagten Anordnungen müssen dabei im wesentlichen "nur" für ein getaktetes Laden und Entladen eines oder auch mehrerer piezoelektrischer Elemente geeignet sein.

An dieser Stelle sei angemerkt, daß Anordnungen nach Art der Figur 7 nicht für ein getaktetes Laden und/oder Entladen von piezoelektrischen Elementen ausgelegt sind. Dort wirken die Lade- und Entladespulen nämlich als das induktive Element eines im Zusammenwirken mit dem piezoelektrische Element gebildeten LC-Reihenschwingkreises, wobei die Induktivität des induktiven Elements und die Kapazität des piezoelektrischen Elements allein den Verlauf und den Umfang des Ladens und des Entladens bestimmen (geladen und entladen werden kann jeweils nur mit der ersten Stromhalbwelle der ersten Schwingkreisschwingung, denn ein Weiterschwingen des Schwingkreises wird durch die im Ladestromkreis und Entladestromkreis enthaltenen Dioden unterbunden).

Im Gegensatz hierzu wird bei zum getakteten Laden und Entladen ausgelegten Anordnungen (beispielsweise bei Anordnungen nach Art der Figur 1) die Spule (oder ein anderes induktive Eigenschaften aufweisendes Element) als ein Energie-Zwischenspeicher verwendet, der abwechselnd von der Stromversorgungsquelle (beim Laden) bzw. vom piezoelektrischen Element (beim Entladen) zugeführte elektrische Energie (in Form von magnetischer Energie) speichert und - nach einer entsprechenden Schalterbetätigung - die gespeicherte Energie in Form von elektrischer Energie an das piezoelektrische Element (beim Laden) bzw. einen anderen Energiespeicher oder einen elektrischen Verbraucher (beim Entladen) abgibt, wobei die Zeitpunkte und die Dauer (und damit auch der Umfang) der Energiespeicherung und der Energieabgabe durch die Schalterbetätigung(en) bestimmt werden.

Dadurch kann das piezoelektrische Element in beliebig vielen, beliebig großen und in beliebigen zeitlichen Abständen aufeinanderfolgenden Stufen wunschgemäß weit geladen und entladen werden.

Nutzt man die gegebenen Möglichkeiten dahingehend aus, daß man die Schalter derart wiederholt öffnet und schließt, daß das piezoelektrische Element durch einen vorgegebenen mittleren Lade- bzw. Entladestrom auf eine vorgegebene Spannung gebracht wird, so können das Laden und das Entladen von piezoelektrischen Elementen schonend für diese und einfach an die individuellen und wechselnden Verhältnisse anpaßbar durchgeführt werden.

Die Betätigung des Ladeschalters 3 und des Entladeschalters 5 erfolgt durch eine in der Figur 1 nicht gezeigte Steuer- oder Regeleinrichtung. Diese Steuer- oder Regeleinrichtung führt ein derartiges Öffnen und Schließen des Ladeschalters 3 und des Entladeschalters 5 durch, daß das zu ladende bzw. zu entladende piezoelektrische Element dadurch unter Einhaltung eines vorgegebenen mittleren (Lade- bzw. Entlade-)Stromflusses auf eine vorgegebene Spannung gebracht wird.

Hierzu werden der Ladeschalter 3 bzw. der Entladeschalter 5 zu bestimmten Zeitpunkten geöffnet und geschlossen, wobei sich die Zeiten, während welcher die jeweiligen Schalter geschlossen sind, und die Zeiten, während welcher die jeweiligen Schalter geöffnet sind, gleich oder unterschiedlich lang sein können und selbst innerhalb eines jeweiligen Lade- bzw. Entladevorganges beliebig verändert werden können.

Der Lade- bzw. Entladestrom, der sich dabei einstellen soll, wird im betrachteten Beispiel unter Berücksichtigung der Temperatur des zu ladenden bzw. zu entladenden piezoelektrischen Elements festgelegt, wobei jedoch der Ladestrom und der Entladestrom während eines jeweiligen Lade- bzw. Entladevorganges im wesentlichen konstant gehalten werden; gegebenenfalls erforderliche Veränderungen des Lade- und/oder Entladestromes können bei Bedarf aber auch während eines Lade- bzw. Entladevorganges durchgeführt werden.

Wie vorstehend bereits erwähnt wurde, wird die Temperatur des piezoelektrischen Elements im betrachteten Beispiel über dessen Kapazität und deren Temperaturabhängigkeit bestimmt.

Die Temperaturabhängigkeit des piezoelektrischen Elements kann durch eine Versuchsmessung bestimmt werden; die Meßergebnisse können in einer Tabelle abgelegt werden oder zur Aufstellung einer Umrechnungsvorschrift verwendet werden.

Die Ermittlung der Temperaturabhängigkeit braucht nur ein einziges Mal durchgeführt zu werden; sofern die Temperaturabhängigkeit veränderlich ist (sich beispielsweise abhängig vom Alter oder der Gebrauchsdauer oder der Gebrauchshäufigkeit des piezoelektrischen Elements ändert), kann auch vorgesehen werden, die Temperaturabhängigkeit in bestimmten zeitlichen Abständen oder im Ansprechen auf bestimmte Ereignisse zu wiederholen.

Bei Kenntnis der Temperaturabhängigkeit der Kapazität des piezoelektrischen Elements kann aus der momentanen Kapazität des piezoelektrischen Elements dessen Temperatur bestimmt werden.

Die Kapazität des piezoelektrischen Elements wird im betrachteten Beispiel nicht direkt gemessen, sondern unter Verwendung der bei einem Ladevorgang oder einem Entladevorgang ermittelten bzw. verwendeten Werte des (Ent-)Ladestroms, der (Ent-)Ladezeit und der sich dadurch am piezoelektrischen Element einstellenden Spannung berechnet. Dabei erweist es sich als vorteilhaft, wenn das (Ent-)Laden unter Verwendung eines bekannten (Ent-)Ladestromes erfolgt und andauert, bis sich am piezoelektrischen Element eine vorbestimmte Spannung einstellt; dann müssen nämlich "nur" die (Ent-)Ladezeit und die sich am piezoelektrischen Element einstellende Spannung gemessen bzw. überwacht werden, was mit einfachen Mitteln und ohne Beeinflussung der Funktion des piezoelektrischen Elements möglich ist.

Die Formel, nach welcher sich die Kapazität des piezoelektrischen Elements aus den genannte Größen berechnen läßt, lautet

$$C_P = \frac{I \cdot \Delta t}{U_P}$$

wobei

$C_P$ die Kapazität des piezoelektrischen Elements
I den (Ent-)Ladestrom
$\Delta t$ die (Ent-)Ladezeit, und
$U_P$ die sich am piezoelektrischen Element einstellende Span- nung

repräsentieren.

Die Kapazität des piezoelektrischen Elements kann auch über das Ausmaß bestimmt werden, um das sich das piezoelektrische Element beim Laden bzw. Entladen desselben ausdehnt bzw. zusammenzieht. Dabei kann man von dem Umstand Gebrauch machen, daß die durch das Laden bzw. Entladen des piezoelektrischen Elements verursachte Längenänderung desselben proportional zu der sich durch das Laden oder Entladen des piezoelektrischen Elementes dort einstellenden Spannung ist, und daß die Spannung, die sich am piezoelektrischen Element einstellt, wenn dieses eine bestimmte Zeit mit einem bestimmten Strom geladen oder entladen wird, im wesentlichen ausschließlich von der Kapazität des piezoelektrischen Elementes abhängt.

Der Zusammenhang zwischen der Längenänderung des piezoeelektrischen Elements, der sich am piezoelektrischen Element einstellenden Spannung, und der Kapazität des piezoelektrischen Elements läßt sich mathematisch durch

$$\Delta l = d_{33} \cdot U_P = d_{33} \cdot \frac{1}{C_P} \cdot I \cdot \Delta t$$

ausdrücken, wobei

$\Delta l$ die Längenänderung am piezoelektrischen Element
$d_{33}$ die piezoelektrische Ladungskonstante

$U_P$   die sich am piezoelektrischen Element einstellende Span- nung
$C_P$   die Kapazität des piezoelektrischen Elements
I   der (Ent-)Ladestrom, und
$t_n$   die (Ent-)Ladezeit

repräsentieren.

Abhängig von der so oder anders ermittelten Temperatur des piezoelektrischen Elements können je nach den individuellen Erfordernissen der (Ent-)Ladestrom, die (Ent-)Ladezeit und/oder die Spannung, auf die das piezoelektrische Element zu bringen ist, variiert werden.

Die Einhaltung der festgelegten Werte wird durch Vorsehen einer die Anordnung gemäß Figur 1 steuernde Steuereinrichtung oder regelnde Regeleinrichtung erreicht, wobei der Stromfluß jedoch sowohl bei der Steuerung als auch bei der Regelung durch ein entsprechend häufiges und langes Öffnen und Schließen des Ladeschalters bzw. des Entladeschalters eingestellt wird.

Im Ergebnis gelangt man sowohl bei der Steuerung als auch bei der Regelung zu einem Laden und Entladen des piezoelektrischen Elements wie es in Figur 6 beispielhaft veranschaulicht ist.

In der Figur 6 repräsentiert

- die mit A bezeichnete Kurve den Verlauf der sich am piezoelektrischen Element einstellenden Spannung,

- die mit B bezeichnete Kurve den Ladestrom bzw. den Entladestrom, durch den das piezoelektrische Element geladen bzw. entladen wird,

- die mit C bezeichnete Kurve den Schaltzustand des Ladeschalters, und

- die mit D bezeichnete Kurve den Schaltzustand des Entladeschalters.

Aus dem wie gezeigt erfolgenden wiederholten Schließen und Öffnen des Ladeschalters (Kurve C) resultiert ein zwar schwankender, aber im Mittel gleichbleibend großer Ladestrom (Kurve B), durch den sich im betrachteten Beispiel am piezoelektrischen Element eine im Mittel gleichmäßig auf einen vorgegebenen Endwert ansteigende Span- nung (Kurve A) einstellt; aus dem wie gezeigt erfolgenden wiederholten Schließen und Öffnen des Entladeschalters (Kurve D) resultiert ein zwar schwankender, aber im Mittel gleichbleibend großer Entladestrom (Kurve B), durch den sich im betrachteten Beispiel am piezoelektrischen Element eine im Mittel gleichmäßig auf einen vorgegebenen Endwert abfallende Spannung (Kurve A) einstellt.

Der mittlere Lade- bzw. Entladestrom, aber auch die Spannung, auf die das piezoelektrische Element zu laden bzw. zu entladen ist, sind im betrachteten Beispiel variabel und können nicht nur in Abhängigkeit von der Temperatur des piezoelektrischen Elements, sondern zusätzlich insbesondere in Abhängigkeit von der pro Einspritzvorgang einzuspritzenden Kraftstoffmenge, der Motordrehzahl, dem Druck im Rail oder der Motortemperatur festgelegt werden.

Die Temperatur des piezoelektrischen Elements und die darauf basierenden Veränderungen (Anpassungen) der veränderbaren Parameter wird dabei vorzugsweise für jede Einspritzdüse separat vorgenommen. Dadurch kann erreicht werden, daß der Betrieb aller Einspritzdüsen unabhängig voneinander optimal an die jeweiligen Verhältnisse anpaßbar ist.

Das beschriebene Verfahren und die beschriebene Vorrichtung zum Ermitteln der Temperatur von piezoelektrischen Elementen ermöglichen es dabei unabhängig von den Einzelheiten deren praktischer Realisierung, die Temperatur von piezoelektrischen Elementen einfach und ohne Beeinflussung deren Funktion zu ermitteln.

**Patentansprüche**

**1.**   Verfahren zum Ermitteln der Temperatur eines piezoelektrischen Elements (1), **gekennzeichnet durch** die Schritte: Ermitteln der Kapazität des piezoelektrischen Elements bei der gesuchten Temperatur, und Bestimmen der gesuchten Temperatur des piezoelektrischen Elements (1) basierend auf der ermittelten Kapazität und der Temperaturabhängigkeit der Kapazität des piezoelektrischen Elements (1), wobei die Kapazität des piezoelektrischen Elements (1) basierend auf den während eines Ladevorganges oder Entladevorganges ermittelten oder verwendeten Werten des Lade-oder Entladestromes, der Lade- oder Entladezeit und der sich **dadurch** am piezoelektrischen Element einstellenden Spannung berechnet wird.

**2.**   Vorrichtung zum Ermitteln der Temperatur eines piezoelektrischen Elements, **dadurch gekennzeichnet dass** Mittel vorgesehen sind, die derart ausgebildet sind, dass diese die Kapazität des piezoelektrischen Elements bei der gesuchten Temperatur ermitteln und die gesuchte Temperatur des piezoelektrischen Elements basierend auf der ermittelten Kapazität und der Temperaturabhängigkeit der Kapazität des piezoelektrischen Elements (1) bestimmen, und dass die Mittel derart ausgebildet sind, dass diese die Kapazität des piezoelektrischen Elements (1) basierend auf den während eines Ladevorganges oder Entladevorganges ermittelten oder verwendeten Werten des Lade- oder Entladestromes, der Lade- oder Entladezeit und der sich **dadurch** am piezoelektrischen Element einstellenden Spannung berechnen.

**3.** Vorrichtung nach Anspruch 2, **dadurch gekennzeichnet, dass** das piezoelektrische Element (1) als Aktor in einer Kraftstoff-Einspritzdüse einer Brennkraftmaschine verwendet wird.

**4.** Vorrichtung nach Anspruch 3, **dadurch gekennzeichnet, dass** die Temperaturermittlung an jeder Kraftstoff-Einspritzdüse durchgeführt wird.

**Claims**

**1.** Method for determining the temperature of a piezo-electric element (1), **characterized by** the steps: determination of the capacitance of the piezo-electric element at the searched-for temperature and determination of the searched-for temperature of the piezo-electric element (1) on the basis of the determined capacitance and the temperature dependence of the capacitance of the piezo-electric element (1), wherein the capacitance of the piezo-electric element (1) is calculated on the basis of the values, which are determined or used during a charging process or discharging process, for the charging current or discharging current, the charging time or discharging time and the voltage which occurs at the piezo-electric element as a result.

**2.** Device for determining the temperature of a piezo-electric element, **characterized in that** means are provided which are embodied in such a way that they determine the capacitance of the piezo-electric element at the searched-for temperature and determine the searched-for temperature of the piezo-electric element on the basis of the determined capacitance and the temperature dependence of the capacitance of the piezo-electric element (1), and **in that** the means are embodied in such a way that they calculate the capacitance of the piezo-electric element (1) on the basis of the values, which are determined or used during a charging process or discharging process, for the charging current or discharging current, the charging time or discharging time and the voltage which occurs at the piezo-electric element as a result.

**3.** Device according to Claim 2, **characterized in that** the piezo-electric element (1) is used as an actuator in a fuel injection nozzle of an internal combustion engine.

**4.** Device according to Claim 3, **characterized in that** the temperature is determined at each fuel injection nozzle.

**Revendications**

**1.** Procédé de détermination de la température d'un élément piézoélectrique (1), **caractérisé par** les étapes qui consistent à
déterminer la capacité de l'élément piézoélectrique à la température étudiée et
à déterminer la température étudiée de l'élément piézoélectrique (1) à partir de la capacité déterminée et de la dépendance de la capacité de l'élément piézoélectrique (1) vis-à-vis de la température,
la capacité de l'élément piézoélectrique (1) étant calculée sur base des valeurs déterminées pendant une opération de charge ou une opération de décharge ou des valeurs utilisées du courant de charge ou de décharge, de la durée de charge ou de décharge et de la tension qui s'établit ainsi sur l'élément piézoélectrique.

**2.** Dispositif de détermination de la température d'un élément piézoélectrique, **caractérisé en ce qu'**il présente des moyens configurés pour déterminer la capacité de l'élément piézoélectrique à la température étudiée et pour déterminer la température étudiée de l'élément piézoélectrique (1) à partir de la capacité déterminée et de la dépendance de la capacité de l'élément piézoélectrique (1) vis-à-vis de la température et **en ce que** les moyens sont configurés de manière à calculer déterminer la capacité de l'élément piézoélectrique (1) sur base des valeurs déterminées pendant une opération de charge ou une opération de décharge ou des valeurs utilisées du courant de charge ou de décharge, de la durée de charge ou de décharge et de la tension qui s'établit ainsi sur l'élément piézoélectrique.

**3.** Dispositif selon la revendication 2, **caractérisé en ce que** l'élément piézoélectrique (1) est utilisé comme actionneur dans un gicleur d'injection de carburant d'un moteur à combustion interne.

**4.** Dispositif selon la revendication 3, **caractérisé en ce que** la température est déterminée sur chaque gicleur d'injection de carburant.

FIG. 1

FIG. 2

FIG. 3

FIG. 4

FIG. 5

FIG. 6

**FIG. 7**

**EP 0 983 614 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0371469 B1
- EP 0379182 B1

- JP 6140682 A

**In der Beschreibung aufgeführte Nicht-Patentliteratur**

- *Patent Abstracts of Japan,* 19. August 1994, vol. 018 (447